# EUROPEAN PATENT APPLICATION

(11) **EP 4 468 330 A1**
(43) Date of publication of application: **27.11.2024**
(21) Application number: 23175027.4
(22) Date of filing: 24.05.2023
(51) Int. Cl.: H01L 21/687, G03F 7/00

(54) **PASSIVE GRAVITY COMPENSATOR FOR SEMICONDUCTOR EQUIPMENT**

(71) Applicant: ETEL S.A., 2112 Môtiers (CH)
(72) Inventor: Mittal, Manish, 2000 Neuchâtel (CH); Jean-Pierre, Morel, 25300 Les Fourgs (FR)
(74) Representative: P&TS SA (AG, Ltd.)

(57) **Abstract**

The invention relates to a passive gravity compensator (10) for a semiconductor equipment (100) comprising a stationary unit (110) and a movable unit (120) arranged to move relative the stationary unit (110) in a Z-direction. The gravity compensator (10) comprises a first assembly (20) having a magnet holder (22) and a permanent magnet (26) fixed to the magnet holder (22). The gravity compensator further comprises a second assembly (30) comprising a magnetic yoke (32) having a first and a second opposite parts (33a, 33b) and a first and a second permanent magnets (35a, 35b) mounted against said first and second opposite parts (33a, 33b) of the magnetic yoke (32) to face each other and to form a gap (34) therebetween. One and the other of the first and second assemblies (20, 30) of the gravity compensator are adapted to be mounted on respectively the stationary unit and movable units (110, 120) of the semiconductor equipment (100) such that the permanent magnet (26) of the first assembly (20) is movable inside the gap (34) between the first and second permanent magnets (35a, 35b) of the second assembly (30). The gravity compensator (10) further comprises a force adjustment device (40) arranged to be mounted on the stationary unit (110) of the semiconductor equipment (100). The force adjustment device (40) is adapted to adjust the relative position between the permanent magnet (26) of the first assembly (20) and the first and second permanent magnets (35a, 35b) of the second assembly (30) along a X or Y direction to adjust the gravity compensation force.

## Description

### Field of the invention

The present invention relates generally to a passive gravity compensator for a semiconductor processing equipment, in particular a wafer holder, comprising a stationary unit and a moveable unit adapted to move in a Z-direction relative to the stationary unit. The invention further relates to a semiconductor equipment comprising such passive gravity compensator.

### Background of the invention

In many applications, such as in the production of semiconductors, many wafer tables which are used to support and to process wafers are typically able to move in the vertical Z-direction. The weight of such wafer tables needs to be supported against the force of gravity by either active or passive gravity-compensation device to reduce or eliminate the effect of the gravity force. Active gravity-compensation devices use actuators to generate the required forces to cancel the gravity forces acting on the semiconductor process equipment. The active gravity-compensation devices advantageously provide compensation capability in a more controllable fashion but are more complicated than passive gravity-compensation devices.

Passive gravity-compensation devices are thus less expensive, more reliable and more durable. Therefore, these passive devices are usually preferred over active devices when they can meet the requirements of a specific application.

CN107885039 discloses an adjustable passive gravity compensator for a semiconductor processing equipment, comprising a fixed assembly and a movable assembly. The movable assembly comprises an inner ring magnet and an outer ring magnet mounted in a magnet housing and arranged concentrically relative to the inner ring magnet. The fixed assembly comprises a cylindrical magnet around which the inner ring magnet of the moveable assembly is mounted. The position of the cylindrical magnet can be adjusted in the Z direction to adjust to the compensating force of the gravity compensator.

An aim of the present invention is to provide a passive gravity compensator with a force adjustment device according to an alternative solution.

### Brief summary of the invention

This aim is achieved by a passive gravity compensator for a semiconductor equipment comprising a stationary unit and a movable unit arranged to move relative the stationary unit in a Z-direction. The gravity compensator comprises a first assembly having a magnet holder and a permanent magnet fixed to the magnet holder. The gravity compensator further comprises a second assembly comprising a magnetic yoke having a first and a second opposite parts and a first and a second permanent magnets mounted against the first and second opposite parts of the magnetic yoke to face each other and to form a gap therebetween. One and the other of first and second assemblies of the gravity compensator are adapted to be mounted on respectively the stationary unit and movable units of the semiconductor equipment such that the permanent magnet of the first assembly is movable inside the gap between the first and second permanent magnets of the second assembly. The gravity compensator further comprises a force adjustment device arranged to be mounted on the stationary unit of the semiconductor equipment and adapted to adjust the relative position between the permanent magnet of the first assembly and the first and second permanent magnets of the second assembly along a direction perpendicular to the Z-direction, preferably along a X or Y-direction, to adjust the gravity compensation force.

In an embodiment, the force adjustment device comprises a guiding system connected to one of the first and second assemblies and adjustment means to move the first assembly towards to or away from the second assembly along said X or Y-direction.

In an embodiment, the guiding system comprises a rail, a slider slidably mounted on the rail and a bracket fixed to the slider. The bracket comprises a base supporting said one of the first and second assemblies and two lateral sides facing two opposite sides of the slider. The adjustment means comprises a screw mounted on a through-hole on each lateral sides of the bracket to move the bracket in either two opposite directions by screwing and unscrewing the screws.

In an embodiment, the screws are arranged to abut against to opposite sides of the rail and are arranged to work in opposition to create a pre-constraint on the guiding system in order to prevent the screws loosening up with time.

In an embodiment, the magnetic yoke comprises a rectangular parallelepiped shaped rear part and two opposite rectangular parallelepiped shaped parts extending perpendicularly from the rear part. The first and second permanent magnets are mounted on two opposite inner sides of the two opposite rectangular parallelepiped shaped parts.

In an embodiment, the magnetic yoke has an external envelope of rectangular parallelepiped shape. The magnetic yoke has a U-shaped transverse section which is constant along the displacement direction of the first assembly relative to the second assembly of the gravity compensator.

In an embodiment, the magnet holder of the first assembly comprises a frame having an opening inside which is mounted the permanent magnet with two opposite sides facing the first and second permanent magnets of the second assembly.

In an embodiment, the first assembly further comprises two L-shaped lateral parts mounted on both sides of the frame and within the same plane of respective opposite parts of the magnetic yoke.

In an embodiment, the polarity of the permanent magnet of the first assembly and the polarity of the first and second permanent magnets of the second assembly are oriented in the same direction.

Another aspect of the invention relates to a semiconductor equipment, in particular a wafer holder, comprising a stationary unit, a movable unit arranged to move relative the stationary unit in a Z-direction and the gravity compensator according to any of the above-described embodiments. The force adjustment device is part of the first assembly of the gravity compensator. The first assembly is mounted on the stationary unit whereas the second assembly is mounted in the movable unit of the semiconductor equipment such that the permanent magnet of the first assembly is movable, at least partly, inside the gap between the first and second permanent magnets of the second assembly.

In an embodiment, the magnetic yoke comprises through-holes and screws arranged in said through-holes and screwed into the movable unit.

### Brief description of the drawings

The invention will be better understood with the aid of the description of embodiments given by way of examples and illustrated by the figures, in which:
- Figure 1 shows a perspective view of a wafer holder, comprising a stationary unit, a movable unit arranged to move relative the stationary unit in a Z-direction and a gravity compensator according to an embodiment, wherein the force adjustment device of the gravity compensator is set in a first position to provide the maximum gravity compensation force;
- Figure 2a shows a perspective view of the gravity compensator of Figure 1;
- Figure 2b shows a side view of the gravity compensator of Figure 2a;
- Figure 2c shows a top view of the gravity compensator of Figure 2a;
- Figure 3 shows a similar view of the wafer holder of Figure 1 with the force adjustment device of the gravity compensator set in a second position to provide an intermediate gravity compensation force;
- Figure 4a shows a perspective view of the gravity compensator of Figure 3;
- Figure 4b shows a side view of the gravity compensator of Figure 4a;
- Figure 4c shows a top view of the gravity compensator of Figure 4a;
- Figures 5a to 5c are schematic side views of the gravity compensator with three different Z positions of the first assembly with respect to the second assembly;
- Figure 6 is a graph showing the gravity compensation force as a function of the position of the first assembly with respect to the second assembly in the Z-direction;
- Figures 7a to 7c are schematic top views of the gravity compensator with three different X positions of the first assembly with respect to the second assembly, and
- Figure 8 is a graph showing the gravity compensation force as a function of the position of the first assembly with respect to the second assembly in the X-direction;

### Detailed description of several embodiments of the invention

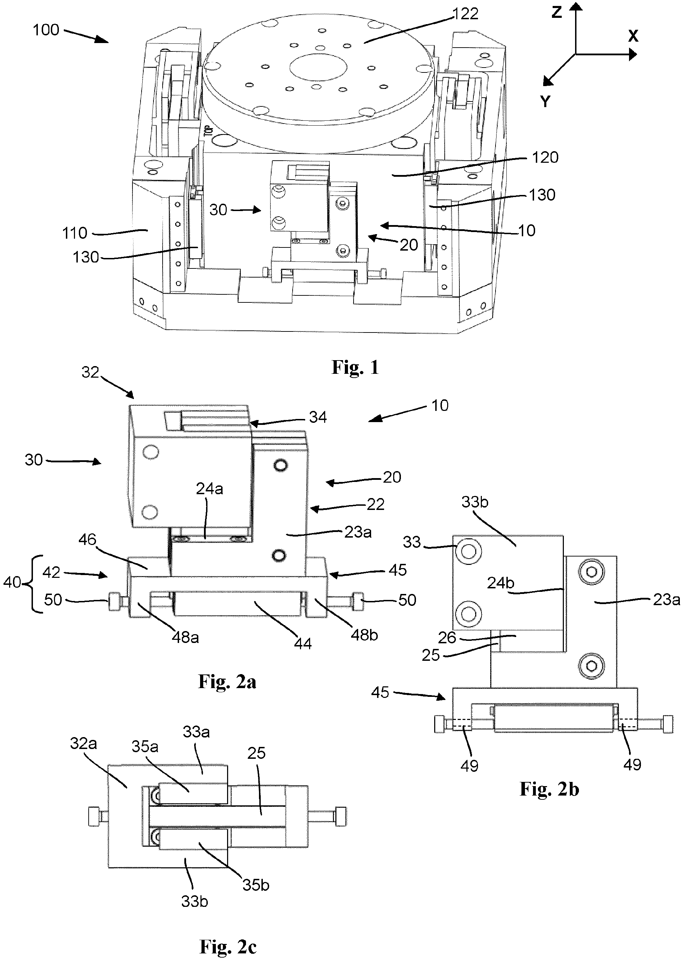

Figure 1 shows a wafer holder 100 comprising a stationary unit 110, a movable unit 120 comprising a wafer chuck 122 and linear bearings 130 mounted between the stationary and movable units 110, 120 to guide the movable unit 120 relative to the stationary unit 110 along a Z-direction. The wafer holder 100 further comprises a gravity compensator 10. The gravity compensator 10 comprises a first assembly 20 fixed to the stationary unit 110 and a second assembly 30 fixed to the movable unit 120 of the wafer holder 100.

With reference to Figures 2a to 2c, the first assembly 20, referred hereafter as the fixed assembly, comprises a magnet holder 22 and a permanent magnet 26 fixed to the magnet holder 22. More particularly, the magnet holder 22 comprises a non-magnetic frame 25 having an opening (not shown) inside which is mounted the permanent magnet 26. Two opposite sides of the magnet 26 extend in the plane of respective opposite sides of the frame 25. The magnet holder 22 further comprises two L-shaped lateral parts 23a, 23b mounted on both sides of the frame 25, and which comprises a first linear edge 24a and a second linear edge 24b extending orthogonally from an end of the first linear edge 24a.

The second assembly 30, referred hereafter as the mobile assembly, comprises a magnetic yoke 32 having a rectangular parallelepiped shaped rear part 32a and two opposite rectangular parallelepiped shaped parts 33a, 33b extending perpendicularly from the rear part 32a towards the second linear edge 24b of respective lateral parts 23a, 23b of the magnet holder 22. The magnetic yoke 32 has an external envelope of rectangular parallelepiped shape with a U-shaped transverse section which is constant along the displacement direction of the mobile assembly 30 relative to the fixed assembly 20 of the gravity compensator 10.

The mobile assembly 30 further comprises a first and a second permanent magnet 35a, 35b mounted on two opposite inner sides of respective opposite rectangular parallelepiped shaped parts 33a, 33b to face each other and to form a gap 34 therebetween. The frame 25 of the magnet holder 22 of the fixed assembly 20 is mounted inside the gap 34 of the mobile assembly 30 such that the permanent magnet 26 is movable relative to the two opposite permanent magnet 35a, 35b along the Z-direction.

The rear part 32a of magnetic yoke 32 comprises through-holes 33 extending between two opposite sides. These through-holes 33 are arranged to receive screws for fixing the mobile assembly 30 to the movable unit 120 of the wafer holder 100.

The gravity compensator 10 further comprises a force adjustment device 40 adapted to adjust the relative position between the permanent magnet 26 of the fixed assembly 20 and the first and second permanent magnets 35a, 35b of the mobile assembly 30 along a X or Y direction to adjust the gravity compensation force.

More particularly, the force adjustment device 40 comprises a guiding system 42, which is part of the fixed assembly 20, and which is fixed to the stationary unit 110 of the wafer holder 100. More particularly, the guiding system 42 comprises a rail 43, screwed onto to the stationary unit 110, a slider 44 slidably mounted on the rail 43 and a bracket 45 fixed to the slider 44. The bracket 45 comprises a base 46 onto which is mounted the magnet holder 22 and two lateral sides 48a, 48b facing two opposite sides of the slider 44.

The adjustment means comprise a screw 50 mounted on a through-hole 49 on each lateral sides 48a, 48b of the bracket 45 to abut with respective opposite sides of the rail 43. The bracket 45 can thus be moved in either two opposite directions by screwing and unscrewing the respective screw 50 to move the fixed assembly 20 towards to or away from the mobile assembly 30. The screws 50 work in opposition to be able to create a pre-constraint on the rail 43 thereby preventing the screws loosening up with time.

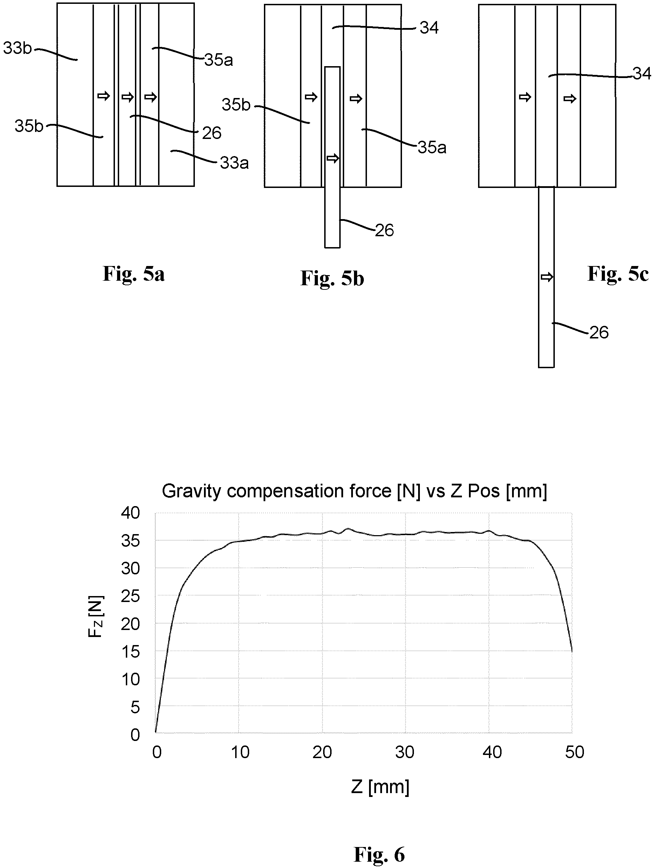

Figures 5a to 5c show three different Z positions of the mobile assembly with respect to the fixed assembly. The polarity of the permanent magnet 26 of the first assembly and the polarity of the first and second permanent magnets 35a, 35b of the second assembly are oriented in the same direction. Due to magnetic interaction between the two assemblies, a force is generated in Z direction. This Z force is constant over some stroke. For example, the relative position between the mobile and fixed assemblies provides 35N of gravity compensation force constant over a stroke of 30 mm as shown in Figure 6.

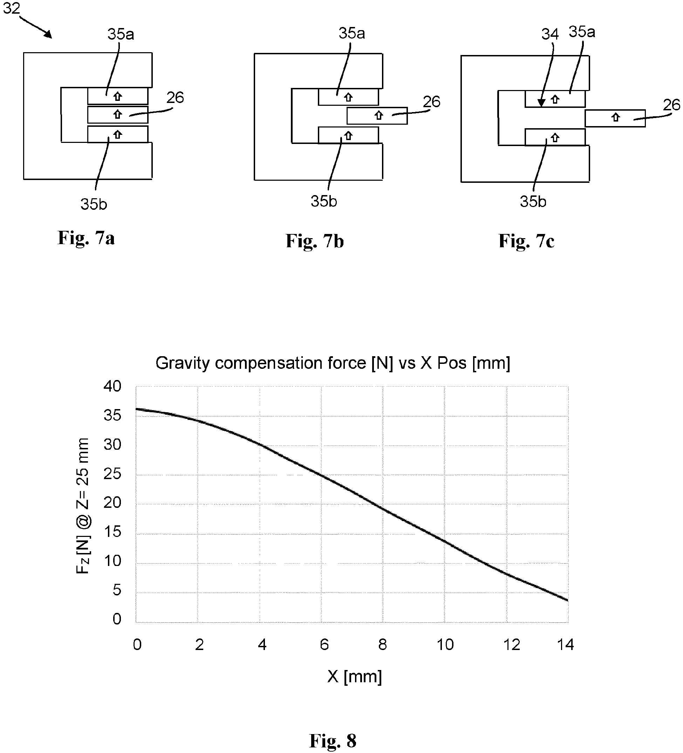

Figures 7a to 7c show three different X positions of the mobile assembly with respect to the fixed assembly. The gravity compensation force can be controlled by varying the X position of the static assembly by the adjustment means 50 of the force adjustment device 40 as described above. The force adjustment device 40 may therefore provide gravity compensation force adjustable in the range of 5 to 35 N as can be seen in Figure 8.

With reference to Figure 8, there is ±10% variation in force with ±1mm of X-variation. Precision in forces required can be controlled by choosing the correct precision of the screws. Typically, ±10% variation in force is acceptable, therefore a standard screw with a precision of ±1mm can be used.

Referring again to Figures 1 and Figures 2a to 2c, the force adjustment device 40 of the gravity compensator 10 is set in a first position to provide the maximum gravity compensation force in the order of 35N. In this position, the two opposite parts 33a, 33b of the magnetic yoke 32 are nearly in contact with the second linear edge 24b of respective lateral parts 23a, 23b of the magnet holder 22 of the first assembly, leaving a small gap in the range of 0.1 mm to allow a contactless movement in the Z direction of the movable unit 120.

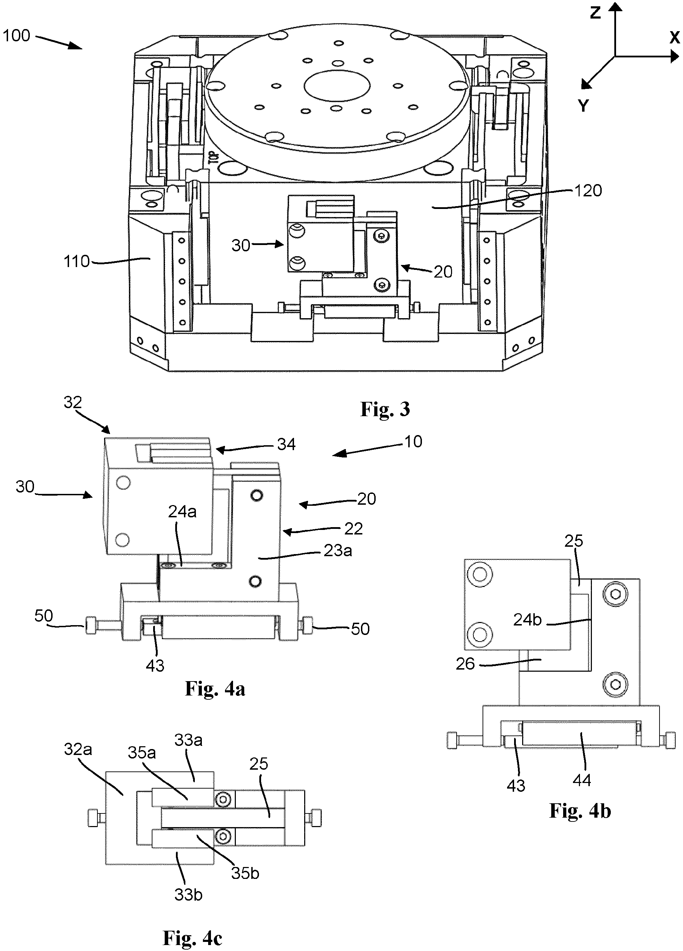

Referring now to Figures 3 and Figures 4a to 4c, the force adjustment device 40 of the gravity compensator 10 is set in a second position to provide an intermediate gravity compensation force in the order of 20-25N as shown in Figure 8.

Various modifications may be brought to the gravity compensator 10 as described above without departing from the scope of the appended claims. For example, the first assembly 20 may be arranged to be fixed to the movable unit 120 of the semiconductor equipment 100 while the second assembly 30 may be arranged to be fixed to the stationary unit 110 of the semiconductor equipment.

### Reference list

Passive gravity compensator 10
   First assembly 20
      Magnet holder 22
         Lateral parts 23a, 23b
            First and second linear edges 24a, 24b Frame 25
      Permanent magnet 26
   Second assembly 30
      Magnetic yoke 32
         Rear side 32a
            Through-holes 33
         Opposite sides 33a, 33b
         Gap 34
      Permanent magnets 35a, 35b
   Force adjustment device 40
      Guiding system 42
         Rail 43
         Slider 44
         Bracket 45
            Base 46
            Lateral sides 48a, 48b
               Threaded through-hole 49
      Adjustment means 50 (e.g. screws)
A wafer holder 100
   Stationary unit 110
   Movable unit 120
      Wafer chuck 122
   Linear bearing 130

## Claims

1. Passive gravity compensator (10) for a semiconductor equipment (100) comprising a stationary unit (110) and a movable unit (120) arranged to move relative the stationary unit (110) in a Z-direction, the gravity compensator (10) comprising a first assembly (20) having a magnet holder (22) and a permanent magnet (26) fixed to the magnet holder (22) and a second assembly (30) comprising a magnetic yoke (32) having a first and a second opposite parts (33a, 33b) and a first and a second permanent magnets (35a, 35b) mounted against said first and second opposite parts (33a, 33b) of the magnetic yoke (32) to face each other and to form a gap (34) therebetween, wherein one and the other of said first and second assemblies (20, 30) of the gravity compensator are adapted to be mounted on respectively the stationary unit and movable units (110, 120) of the semiconductor equipment (100) such that the permanent magnet (26) of the first assembly (20) is movable inside the gap (34) between the first and second permanent magnets (35a, 35b) of the second assembly (30), and wherein the gravity compensator (10) further comprises a force adjustment device (40) arranged to be mounted on the stationary unit (110) of the semiconductor equipment (100) and adapted to adjust the relative position between the permanent magnet (26) of the first assembly (20) and the first and second permanent magnets (35a, 35b) of the second assembly (30) along a direction orthogonal to the Z-direction, preferably along a X or Y-direction, to adjust the gravity compensation force.

2. Gravity compensator (10) according to claim 1, wherein the force adjustment device (40) comprises a guiding system (42) connected to one of the first and second assemblies (20, 30) and adjustment means (50) to move the first assembly (20) towards to or away from the second assembly (30) along said X or Y direction.

3. Gravity compensator (10) according to the preceding claim, wherein the guiding system (42) comprises a rail (43), a slider (44) slidably mounted on the rail (43), a bracket (45) fixed to the slider (44), said bracket (45) comprising a base (46) supporting said one of the first and second assemblies (20, 30) and two lateral sides (48a, 48b) facing two opposite sides of the slider (44), said adjustment means comprises a screw (50) mounted on a through-hole (49) on each lateral sides (48a, 48b) of the bracket (45) to move the bracket (45) in either two opposite directions by screwing and unscrewing the respective screw (50).

4. Gravity compensator (10) according to the preceding claim, wherein the screws (50) are arranged to abut against to opposite sides of the rail (43) and are arranged to work in opposition to create a pre-constraint on the guiding system (42) thereby preventing the screws loosening up with time.

5. Gravity compensator (10) according to any preceding claim, wherein the magnetic yoke (32) comprises a rectangular parallelepiped shaped rear part (32a) and two opposite rectangular parallelepiped shaped parts (33a, 33b) extending perpendicularly from the rear part (32a), wherein the first and second permanent magnets (35a, 35b) are mounted on two opposite inner sides of said two opposite rectangular parallelepiped shaped parts (33a, 33b).

6. Gravity compensator (10) according to any preceding claim, wherein the magnetic yoke (32) has an external envelope of rectangular parallelepiped shape, and wherein said magnetic yoke (32) has a U-shaped transverse section which is constant along the displacement direction of the first assembly (20) relative to the second assembly (30) of the gravity compensator (10).

7. Gravity compensator (10) according to any preceding claim, wherein the magnet holder (22) of the first assembly (20) comprises a frame (25) having an opening inside which is mounted the permanent magnet (26) with two opposite sides facing the first and second permanent magnets (35a, 35b) of the second assembly (30).

8. Gravity compensator (10) according to the preceding claim, wherein the first assembly (20) further comprises two L-shaped lateral parts (23a, 23b) mounted on both sides of the frame (25) and within the same plane of respective opposite parts (33a, 33b) of the magnetic yoke (32).

9. Gravity compensator (10) according to any preceding claim, wherein the polarity of the permanent magnet (26) of the first assembly (20) and the polarity of the first and second permanent magnets (35a, 35b) of the second assembly (30) are oriented in the same direction.

10. A semiconductor equipment (100), in particular a wafer holder, comprising a stationary unit (110), a movable unit (120) arranged to move relative the stationary unit (110) in a Z-direction and the gravity compensator (10) according to any preceding claim, wherein the force adjustment device (40) is part of the first assembly (20) of the gravity compensator, and wherein said first assembly (20) is mounted on the stationary unit (110) and said second assembly (30) is mounted in the movable unit (120) of the semiconductor equipment (100) such that the permanent magnet (26) of the first assembly (20) is movable inside the gap (34) between the first and second permanent magnets (35a, 35b) of the second assembly (30).

11. The semiconductor equipment (100) according to the preceding claim, wherein the magnetic yoke (32) comprises through-holes (33) and screws arranged in said through-holes (33) and screwed into the movable unit (120).
